# EUROPEAN PATENT SPECIFICATION

(11) **EP 3 240 652 B1**
(45) Date of publication and mention of the grant of the patent: **04.09.2019**
(21) Application number: 15826183.4
(22) Date of filing: 21.12.2015
(51) Int. Cl.: B23K 26/03, B23K 26/362, B23K 26/402, H01L 31/0463

(54) **APPARATUS FOR LASER SCRIBING**
VORRICHTUNG ZUM RITZEN MITTELS LASER
APPAREIL DE GRAVURE AU LASER

(30) Priority: 31.12.2014 WO PCT/EP2014/025031
(43) Date of publication of application: 08.11.2017
(73) Proprietor: Flisom AG, 8155 Niederhasli (CH)
(72) Inventor: ZILTENER, Roger, 6210 Sursee (CH); NETTER, Thomas, 8400 Winterthur (CH)
(74) Representative: Parrini, Lorenzo
(86) International application number: PCT/IB2015/059832
(87) International publication number: WO 2016/108139

(56) References cited:
- JP-A- 2011 198 965

## Description

The present invention relates to apparatuses used to scribe devices, such as thin-film devices, for example vias and monolithic interconnects in thin-film optoelectronic devices such as between cells of photovoltaic modules.

### Background of the invention

Apparatuses specifically designed for laser scribing of thin-film devices such as known from JP-A-2011 198965 help reduce the cost and increase manufacturing productivity and quality of thin-film photovoltaic devices such as flexible thin-film photovoltaic modules.

Thin-film photovoltaic modules are generally composed of a number of electrically interconnected optoelectronic components. Such components may be optoelectronic devices such as photovoltaic cells and additional optional components such as diodes and other electronic devices. Photovoltaic modules usually also include electrically interconnecting components such as cell-to-cell connectors and busbars.

Multilayer thin-film technologies enable the monolithic integration and interconnection of several optoelectronic components and associated components on a same substrate. This integration is produced in situ using a sequence of layer deposition and scribing techniques.

Thin-film optoelectronic or photovoltaic components or devices are essentially composed of a stack of three material layers: a conducting back-contact electrode layer, a semiconductive photovoltaic material layer, also known as the absorber, and another conducting front-contact electrode layer, said front-contact layer usually being transparent. Photovoltaic cells based on semiconductive material, such as Cu(In,Ga)Se₂ which is abbreviated CIGS, show a high potential for less expensive solar electricity, lower energy payback time, and improved life-cycle impact compared to traditional wafer-based silicon photovoltaic devices or solar cells.

Compared to wafer-based photovoltaic devices, monolithic thin-film photovoltaic modules may have lower costs thanks to reduced material quantities used to form the thin films that form part of the photovoltaic components, reduced labor costs of monolithic integration, and ease of automatic production of large quantities of photovoltaic modules, for example using roll-to-roll manufacturing techniques. Photovoltaic module production yields may also be increased thanks to a reduction in the number of production steps, for example by reducing the number of scribing operations needed to delineate and structure the interconnects of optoelectronic components in thin-film monolithic photovoltaic modules.

An optoelectronic device can be described in a simplified way as an absorber layer sandwiched between a first and a second electrode. The process of dividing the device into at least two serially-interconnected devices comprises: scribing at least one so-called P1 scribe into a first electrode, thereby dividing the first electrode into at least two electrically separate components; preferably adjacent to the P1 scribe, scribing a so-called P2 scribe into at least the absorber layer so as to provide means to form an electrical connection between a component of the first electrode and a second electrode; and preferably adjacent to the P2 scribe, scribing a so-called P3 scribe into at least the second electrode so as to separate the second electrode into at least two electrically separate second electrode components. The P2 scribe is located between the P1 and the P3 scribes.

U.S. Pat. No. 7,276,724 describes series-interconnected optoelectronic device modules thanks to the forming of wrap-through vias, for example using laser ablation, and the addition of conductive material to drive current between electrodes as well as to adjacent modules. Wrap-through vias usually require drilling and subsequent metalizing. This requires additional production steps which may add costs and decrease yield. Some of these steps are avoided with the monolithic optoelectronic module production method of WO2011/148346 which describes forming via holes with copper-rich CIGS-type walls derived from partial melting of the absorber layer's CIGS material. The present invention also builds upon PCT/IB2014/058708, filed 31 January 2014.

There is a need for apparatuses and methods to industrially form via holes and scribes ordinarily associated to monolithic thin-film interconnects. For some applications, there is also a need for an apparatus and methods to form thin-film optoelectronic devices that comprise via holes shaped as line segments and variations thereof.

### Summary of the invention

A problem in the field of monolithic photovoltaic module production relates to apparatuses to scribe materials at high speed. More specifically, the problem relates to scribing of thin-film layers on a substrate. Said substrate may be flexible and may be delivered to the scribing apparatus using reel-to-reel means. In greater detail, said apparatus may enable methods to reliably manufacture highly conductive interconnects between photovoltaic components, such as photovoltaic cells. Said interconnect may comprise via holes. An embodiment of the apparatus provided herein may enable a method to reliably interconnect cells of thin-film monolithic photovoltaic module devices at decreased cost and high production yield. Said method may comprise software to control the apparatus. The apparatus may also be used to manufacture interconnects between various components of monolithic photovoltaic modules that may comprise photovoltaic cells, diodes, grids, and busbars. The apparatus and associated method's speed and large processing window are advantageous to industrial production of monolithic photovoltaic module devices using roll-to-roll production methods. Embodiments of devices manufactured by the apparatus may further comprise thin-film optoelectronic devices that comprise via hole line segments.

A problem in the field of manufacturing of monolithic interconnects is that it requires high precision scribing of thin-film layers to form troughs such as lines or line segments, the depth, width, length, shape, cross-section, and distance to adjacent, such as other troughs, should be carefully controlled.

A further problem is that said scribing may be done using lasers which release heat into the thin-film material being scribed and said heat may alter the physical properties, such as composition or conductivity, of the material surrounding the location where the heat is applied.

A corresponding problem when using lasers is that the processing window requires very careful adjustment of laser scribing parameters, even more so when laser scribing photovoltaic materials are formed on a flexible substrate.

Another problem is that a monolithic interconnect ordinarily requires a plurality of scribes which are scribed at different depths into the thin-film layers and ordinarily scribed spatially very near to each other.

A further problem is that scribing a plurality of scribes is time-consuming and therefore increases the cost of the final product.

Another problem is that variations in the material to be scribed, such as composition or thickness, the location of the material relative to the scribing means of the apparatus, or the scribing conditions may cause the cross-section of a scribe not to correspond to that desired by the manufacturer. Furthermore, monolithic interconnects may exhibit variations in the manufactured repeatability of their conductivity.

Yet another problem is that the shape of the scribing laser's spot at the surface of the device being scribed may affect the shape and cross-section of the scribe.

Yet another problem is that laser scribing may damage various layers of the photovoltaic material and cause cracks and local layer delamination of the materials from the flexible substrate. This is especially true when scribing with pulsed lasers.

Embodiments of the apparatus may therefore enable a scribing method, preferably using a laser, where heat generated by the scribing process locally transforms material layers surrounding the scribed cavities so as to cause increased conductivity, thereby enabling the design and production of cost-efficient series-interconnected optoelectronic components and subsequent monolithic optoelectronic module apparatuses.

One embodiment of the apparatus may comprises means to provide a substrate coated with at least one thin-film layer to be scribed. Said thin-film layer may comprise photovoltaic material, such as a CIGS cell or a module where the back-contact layer may have been patterned with cells. The apparatus may be used for scribing lines into the thin-film material so as to form at least one conductive monolithic interconnect between a portion of the back-contact layer and a portion of the front-contact layer. Said scribing may comprise scribing line segment via holes.

Embodiments of the disclosure may thus provide a computer-controlled apparatus for laser scribing at least one line segment via hole in a thin-film device that comprises on a first side of at least one substrate, at least: one front-contact layer; one semiconductive optoelectronically active layer; one back-contact layer; wherein the apparatus comprising: at least one laser source emitting at least one laser beam; means comprising at least one mirror that cooperates with said at least one laser beam to form at least one laser spot on the first side of said device; at least one actuator configured to move at least one laser spot for laser scribing the thin-film device along at least one direction by delivering laser power to said thin-film device; at least one optical sensor configured to acquire imaging data of said first side of said at least one line segment via hole, and at least one control system, comprising a processing unit and a memory unit, for executing instructions for processing said imaging data, said control system being operative to execute: image processing instructions for measuring in the imaging data, along a direction that is orthogonal to at least one direction of laser scribing said at least one line segment via hole: a first characteristic of a line segment via hole, namely the width of a curl-up of the back-contact layer; a second characteristic of a line segment via hole, namely the width of a lip of conductive alloy resulting from a permanent change in the chemical composition of the semiconductive optoelectronically active layer where the line segment via hole is drilled.

In said apparatus, the image processing instructions may comprise instructions wherein image data in at least one portion of an image of at least one line segment via hole is smoothed and where the amount of smoothing in a direction parallel to said direction of laser scribing is greater than in any other direction. Furthermore, the control system may comprise instructions for adjusting at least one actuator as a function of at least one of: said first characteristic of a line segment via hole, namely the width of a curl-up of the back-contact layer; said second characteristic of a line segment via hole, namely the width of a lip of said conductive alloy resulting from a permanent change in the chemical composition of the semiconductive optoelectronically active layer where the line segment via hole is drilled. Still further, the control system may comprise means to control laser power. Furthermore, during motion of the at least one laser beam spot for drilling of the line segment via hole, the distance where laser power is delivered may comprise at least one laser power increase distance portion comprising a progressive increase in power. Still further, the control system may comprise instructions to scribe at least one line comprising a plurality of line segment via holes. Furthermore, said at least one laser source may comprise at least a first laser source which is a continuous wave laser and at least a second laser source which is a pulsed laser. In more detail, the continuous wave laser and the pulsed laser may operate simultaneously. In further detail, the means to form at least one laser spot may comprise at least one scanner lens wherein a continuous wave laser beam of the continuous wave laser and a pulsed laser beam of the pulsed laser pass through said scanner lens. The apparatus may further comprise at least one beam shaper configured to adjust the shape of the continuous wave laser beam. Furthermore, the control system may comprise instructions to adjust the beam shaper. In more detail, the instructions to adjust the beam shaper may comprise instructions to configure the beam shaper to produce an irradiance distribution of the at least one laser spot formed by the continuous wave laser beam that is not symmetrical with respect to an axis parallel to the direction of laser scribing. The apparatus may further comprise means to automatically adjust the scanner lens so that the focus of the at least one laser spots remain constant. Furthermore, the at least one actuator may be configured to adjust the position of at least one laser spot comprises means to adjust the angle of at least one mirror. Still further, the at least one actuator configured to adjust the position of at least one laser spot device may comprise at least one rail configured to translate said at least one mirror. The apparatus may further comprise means to transport said thin-film device. The apparatus may further comprise a device vacuum support. The apparatus may further comprise means to illuminate the layer-comprising first side of the thin-film device from a first position for a first image acquisition and from a second position for a second image acquisition, the first position and the second position being separated by a baseline distance along a direction that is orthogonal to said direction of scribing. Still further, the apparatus may comprise at least one source of structured light.

### Advantages

Embodiments of the disclosure provided herein may advantageously solve several problems in the field of manufacturing of thin-film photovoltaic devices, and more specifically roll-to-roll manufacturing of photovoltaic devices or modules of interconnected optoelectronic components, such as photovoltaic modules manufactured on flexible substrates. For thin-film flexible photovoltaic devices manufactured using one or more of the embodiments or methods described herein, the advantages obtainable over conventional devices may include:
- Faster laser scribing of devices, such as photovoltaic thin-film devices,
- High precision control, repeatability, and automation of laser scribing processes,
- Enlarged laser scribing process window,
- Simultaneous laser scribing of device features having same or different characteristics,
- Higher photovoltaic conversion efficiency,
- Greater strength of monolithic interconnects,
- Greater manufacturing yield,
- Greater range of designs
- Greater photovoltaic module reliability,
- Lower manufacturing costs.

The listed advantages provided above should not be considered as necessary for use with one or more of the embodiments described herein, and are not intended to be limiting as to the scope of the invention described herein.

One of the benefits of the manufacturing apparatus enabling laser scribing methods, at least one of which is described herein, includes the formation of line segment via holes. Line segment via holes may be especially useful for monolithic interconnects in thin-film devices as well as to provide connections to busbars and even to non-shadowing busbars.

### Brief description of figures

FIG. 1 shows the optical layout for a laser subsystem of a laser scribing apparatus.
FIG. 2 shows a top view of a reel-to-reel laser scribing system.
FIGS. 3A-3D show views of a the thin-film CIGS module comprising a plurality of line segment via holes.
FIGS. 4A-4B show a top view, or view of the light-exposed side, of a line segment via hole and a graph of the corresponding laser power used to laser scribe the line segment via hole.
FIG. 5 is a graph of laser power versus time used to scribe a sequence of line segment via holes.
FIG. 6 is a digram illustrating key functions of a laser scribing apparatus.
FIGS. 7A-7F illustrate the irradiance distribution of a laser spot used for laser scribing.
FIGS. 8A-8D illustrate the image processing for measuring line segment via hole characteristics.

### Detailed description of specific embodiments

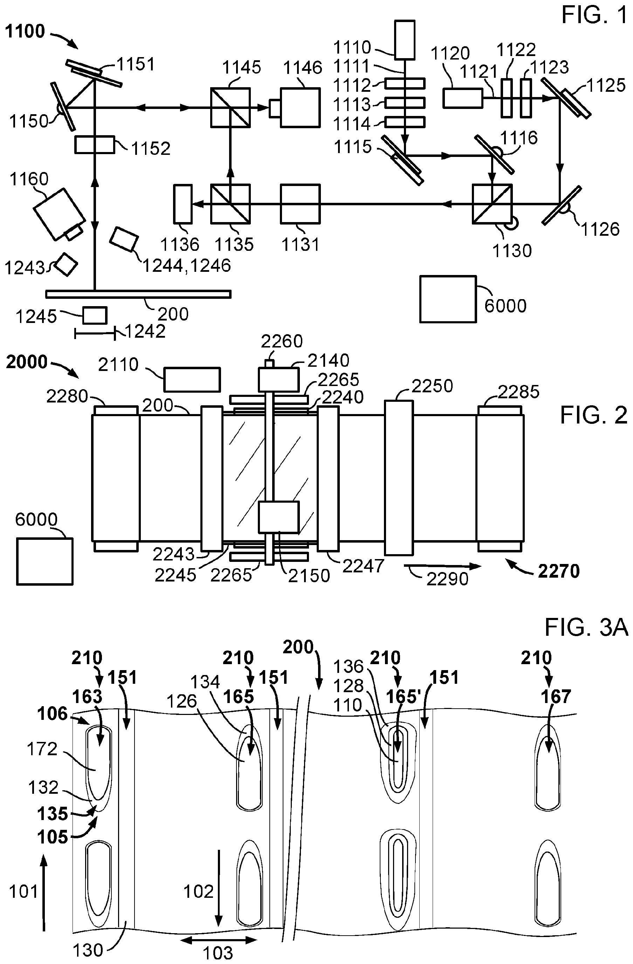

FIG. 1 shows the optical layout for at least one laser subsystem 1100 for a laser scribing apparatus 2000, an embodiment of which is shown in FIG. 2. Briefly, the beams of at least two laser sources 1110, 1120 are combined to scribe adjacent troughs into a device 200. The device 200 is ordinarily a thin-film device. The device is preferably a photovoltaic device. The device may for example be a thin-film device comprising an absorber layer that comprises CIGS semiconductive material. The device may comprise a flexible substrate. The flexible substrate may for example be a web comprised in a device transport system 2270 (shown in FIG. 2), for example a web transport system. The device 200 may ordinarily be transported along a direction of displacement 2290, also called the longitudinal direction. The longitudinal direction 2290 and the corresponding perpendicular direction, also called transverse direction, in the device's plane serve as a frame of reference for the description of apparatuses in this invention.

The laser subsystem 1100 comprises at least one first laser source 1110 forming at least one first laser beam 1111. The first laser source is preferably a continuous wave laser source. Characteristics of the continuous wave laser source and/or of the beam's spot at the surface of the device being laser scribed are provided in further sections of the description. To form or improve the irradiance profile of the first laser beam, a person skilled in the art may optionally pass the laser beam through any one of, or any combination of, preferably in the following order: at least one first laser collimator 1112, at least one first laser polarizing filter 1113, and/or at least one first laser beam shaper 1114. The laser beam shaper 1114 may be controlled, for example by an automatic control system. The laser beam shaper may be controlled to regulate the shape of the irradiation pattern of the laser beam's spot at the surface of the device being scribed. The laser beam's spot may for example be controlled by the laser beam shaper to remain constant during the laser scribing process. The laser beam's spot may also, for example, be controlled by the laser beam shaper to vary in shape during the laser scribing process so as to, for example, facilitate the scribing of patterns. An example of a pattern is a line segment via hole 163 as shown in FIG. 3A. The laser beam shaper 1114 may optionally comprise at least one of, for example, a wavefront shaper, an airy disc shaper, a laser's intra cavity controlled mirror, an optionally actuated fiber bundle, a deformable mirror, a profile shaper, means to generate astigmatism, and/or means to form and/or distort coma. Said means for astigmatism and/or coma may for example comprise thermally controlled and/or a mechanically controlled optics. The laser subsystem 1100 may also optionally comprise at least one second laser source 1120 forming at least one second laser beam 1121. The second laser source is preferably a picosecond pulsed laser source, the characteristics of which are provided in further sections of the description. To form or improve the irradiance profile of the second laser beam, a person skilled in the art may optionally pass the laser beam through any one of, or any combination of, preferably in the following order: at least one second laser collimator 1122, and/or at least one second laser polarizing filter 1123.

An objective of the laser subsystem 1100 is to enable simultaneous laser scribing of at least two laser traces. Examples of laser traces are presented in FIG. 3A where a first laser trace is a line 210 of line segment via holes and a second laser trace is a front contact layer groove 151. The first and second laser traces are preferably scribed very close to each other, preferably with a separation distance that remains constant and is preferably in the range from 0 to 500 µm, preferably from 5 µm to 100 µm. The laser subsystem may therefore comprise means to control the position of the first laser trace with respect to the position of the second laser trace. The laser subsystem may preferably comprise means to independently control the position of any laser trace, for example that of the first laser trace and that of the second laser trace. The laser subsystem 1100 preferably comprises at least one first, continuous wave, laser source 1110, and at least one second, picosecond pulsed, laser source 1120, the beams 1111, 1121 of which converge towards a beam combiner 1130. FIG. 1 presents means to adjust, preferably control, the position of at least one laser trace. Said means adjust, preferably control, the angle at which at least one laser beam 1111, 1121 enters at least one beam combiner 1130. Said means may for example comprise at least one mirror assembly. For example, the first laser beam 1111 may be reflected by a first laser first mirror assembly 1115. Said mirror assembly may comprise actuation means, for example using a piezo-electric actuator, to adjust or control the laser beam in pan, tilt, or pan and tilt. FIG. 1 also illustrates a first laser second mirror assembly 1116. The second mirror assembly 1116 may comprise actuation means that are similar to those of the first mirror assembly 1115. However, a person skilled in the art may for example control the first mirror in pan and the second mirror in tilt, or conversely. The first and second mirrors may comprise actuation means operating at different rates and/or different precision. For example the first mirror may be used for gross, high angular rate control of the laser beam, and the second mirror for fine angular tuning. An arrangement of mirrors 1125, 1126 comparable to that for the first laser beam 1111 is represented for the second laser beam 1121. A person skilled in the art may also choose, for example, to actuate at least one mirror in pan for the first laser beam 1111 and actuate at least one mirror in tilt for the second laser beam 1121. The beam combiner 1130, too, may also comprise at least one actuator for adjustments and/or control in pan, tilt, or pan-tilt. The beam combiner 1130 may comprise any of at least one semi-transparent mirror, a pellicle mirror, a dichroic mirror, a dichroic filter, or any device enabling combining of beams.

Laser beams 1111, 1121 may pass through at least one beam expander 1131. The beam expander may be configured to truncate a laser beam's spot. The at least one beam expander is ordinarily positioned so that the light exiting the beam combiner then enters the beam expander. A first beam splitter 1135 may also be positioned on the paths of the laser beams 1111, 1121 after exit from the beam combiner, preferably after exit from the beam expander. A purpose of the first beam splitter is to provide means to direct a portion of light from at least one beam 1111, 1121 to a beam alignment sensor 1136. The beam alignment sensor may for example comprise at least one position sensitive detector (PSD) or at least one quadrant photodetector. A second beam splitter 1145 may also be positioned on the paths of the laser beams 1111, 1121, preferably after exit from the first beam splitter. A purpose of the second beam splitter is to provide means to direct a portion of light along a returning path from the device 200 into at least one scribe imaging camera (SIM) 1146. Beam splitters 1135, 1145 may comprise any of at least one semi-transparent mirror, a pellicle mirror, a dichroic mirror, a dichroic filter, or any device enabling splitting of a beam of light into at least two separate beams.

Laser beams 1111, 1121 may be reflected by at least one scanner mirror assembly 1150, 1151 into at least one scanner lens 1152. The at least one scanner mirror assembly 1150, 1151 ordinarily comprises at least one mirror. The mirror may be configured to be oriented at a fixed angle. Said configuration may require translating, or transporting, the scanner mirror assembly to perform laser scanning of the device 200 to be scribed. Preferably, the mirror is configured so that it can be actuated by changing its orientation around at least one axis. The arrangement of the at least one scanner mirror assembly 1150, 1151 may therefore be conceptually similar to that of the pan, tilt, or pan-tilt mirrors 1115, 1116, 1125, 1126. At least one motor of the scanner mirror assembly may comprise at least one electromagnetic motor or at least one piezoelectric motor, or an assembly of both types of motors. The scanner mirror assembly 1150, 1151 provides means to scan at least one laser beam 1111, 1121 onto the device 200. Scanning is preferably at least along first directions 101, 102 (FIG. 3A) that are perpendicular to the longest length of device 200. Scanning may therefore preferably be at least be along first directions that are perpendicular to the direction of displacement 2290 (FIG. 2) of a device within the laser scribing apparatus 2000. Scanning may also be at least along second directions that are preferably perpendicular to the first directions. The scanning mirrors may therefore enable at least one laser spot of at least one laser beam to describe two-dimensional patterns that enable the scribing of two-dimensional patterns at the surface of the device 200. The at least one scanner lens 1152 may comprise at least one of: a cylindrical lens; an achromatic lens; and preferably an f-theta lens.

The laser subsystem 1100 may also comprise device optical monitoring means (OMM) 1160 positioned on the same side of the device as the SIM but outside the optical path of at least one of laser beams 1111, 1121. The device OMM may comprise a camera. The OMM may preferably have optical detection characteristics that are different from that of the SIM.

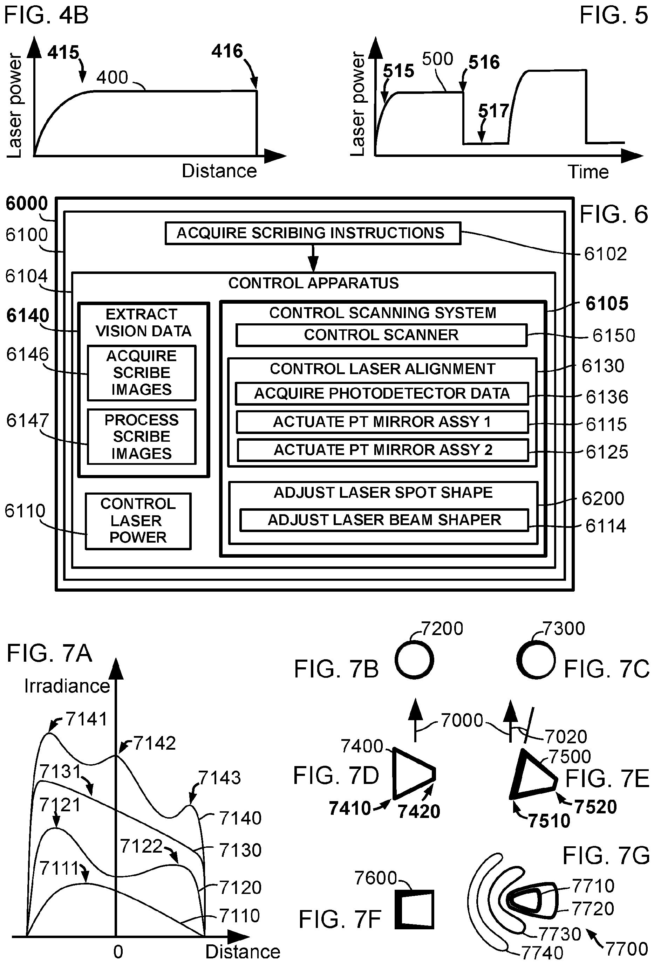

At least one of the SIM 1146 and OMM 1160, thereafter called cameras, may provide means to measure at least one feature of at least one laser scribing spot, thereby enabling real-time adjustment of at least one laser spot characteristics. Said at least one feature may comprise at least one of: spot intensity, spot geometry, spatial variations of spot intensity, and time variations of said features. At least one of the cameras 1146, 1160 may also provide means to measure the distance between scribes. For example it may enable to track the separation between P1 and P2, P2 and P3, P1 and P3, a first P2 scribe and a second P2 scribe, thereby enabling real-time adjustment of laser scribing position, for example with respect to other scribes. Over a wider viewfield, the camera may also enable measurement of the distance between at least two scribes of the same type, for example P1 to P1 distance. The camera may also enable measurement of scribe width thereby enabling real-time adjustment of laser scribing parameters. The camera may enable detection and measurement of particles, for example resulting from laser ablation, thereby enabling real-time control of means to clean said particles, for example using blowing means. The camera may enable detection of defects, wrinkles, or deformations in the device 200 being scribed, thereby enabling corrective actions such as adjustment of laser scribing parameters, adjustment of the laser scribing trace, or raising an alarm. Said camera may comprise at least one of: a CMOS sensor, a CCD sensor, an InGaAs sensor. The camera may comprise, or interface with, a computer 6000 comprising at least one processing unit and at least one memory unit configured to execute software instructions 6100 to acquire and process at least a first set of scribe imaging data 6146 (FIG. 6), thereby enabling or improving detection of features detected on the device 200. Said software instructions may process information originating from at least one camera. Monitoring of the device using at least one camera ordinarily occurs during the laser scribing and may enable real-time adjustment of parameters used to scribe the device.

To improve monitoring and detection using cameras 1146, 1160, the laser subsystem may comprise at least one first overhead lighting means (OLM) 1243 to illuminate at least a portion of the device 200, for example the portion at the time where laser scribing is taking place. An OLM illuminates the device from the same side of the device as that closest to the illumination of the at least one laser beam. Said first OLM may illuminate at a first angle and a first field of illumination (FOI) that is wide enough to enable simultaneous observation and measurement of a plurality of laser scribes, enable their comparison, and enable real-time adjustments of laser scribing parameters. The first OLM may comprise at least one of: a light emitting diode (LED), a structured light pattern, and lighting means for non-contact surface metrology. The OLM may illuminate the device 200 with a plurality of illumination wavelengths. A preferred first OLM may comprise means to provide white light, for example using at least one phosphor-coated blue LED. The laser subsystem may also comprise at least one second OLM 1244. Said second OLM may illuminate the device at one or a combination of: a second angle, a second FOI, and a second illumination wavelength, thereby providing means to simultaneously obtain at least a second set of scribe imaging data that is different from the first set of scribe imaging data. The first OLM and the second OLM are preferably separated by a baseline distance 1242 along a direction that is perpendicular to the direction of scribing lines of line segment via holes 101, 102. The OLM may further comprise structured lighting means 1246 to project a pattern of light onto the surface of the device.

The laser subsystem 1100 may also comprise at least one through substrate lighting means (TSLM) 1245 configured to illuminate the device 200 from the side of the device that is opposite to that observed by the cameras 1146, 1160. The ULM 1245 preferably illuminates at least one portion of the device where laser scribing is taking place. The ULM may also be configured to illuminate a region where laser scribing has taken place. The ULM takes advantage of the fact that the device's substrate is transparent to light. The ULM may be positioned so that direct laser radiation does not impinge onto the ULM. The ULM may be configured so that the lighting it provides radiates directly into at least one of: the scanner lens 1152, thereby facilitating a measurement by the SIM 1146; the OMM 1160. The ULM preferably comprises a linear light source (LLS) the long side of which is parallel with the most used scribing direction 101, 102 (FIG. 3A). The long side of the LLS will preferably be aligned with a direction perpendicular to that of the motion of the device 200 with respect to the laser subsystem 1100. The length of the long side of the LLS will preferably at least be the maximum, continuous or discontinuous, straight line distance that can be scribed across the transverse direction, perpendicular to the longitudinal direction 2290 in the laser scribing system 2000. More generally, the length of the LLS will be at least that of the width of the device 200 in said transverse direction. The ULM may comprise at least one LED. The LED may provide at least one of visible light or infrared light. Infrared light wavelengths are comprised in the range from 850 nm to 1400 nm, preferably from 1200 nm to 1400 nm, more preferably at about 1300 nm. The ULM may be embedded or contained in a device support 2240 (FIG. 2).

Said software may comprise a method to measure features of laser scribes and detect defects by combining and comparing imaging data obtained by illumination by at least two lighting means 1243, 1244, 1245, 1246. Said lighting means may alternate their operation so that separate imaging data may be acquired under a plurality of illuminating conditions. Relative displacement of the device 200 to monitor the device with respect to the OMM 1160 or the SIM 1146 may contribute to producing or enhancing measurements of characteristics of at least one laser scribe or at least one defect. The software may for example comprise at least one of: image differencing methods, structured light analysis methods, structure from motion methods, three-dimensional vision methods, and four-dimensional light field methods. Software instructions may therefore enable at least one of: detection and measurement of at least one alignment mark on the device or outside the device, detection and measurement of at least one scribe line, control of laser scribing with respect to at least one alignment mark, and control of laser scribing with respect to at least one previously scribed line.

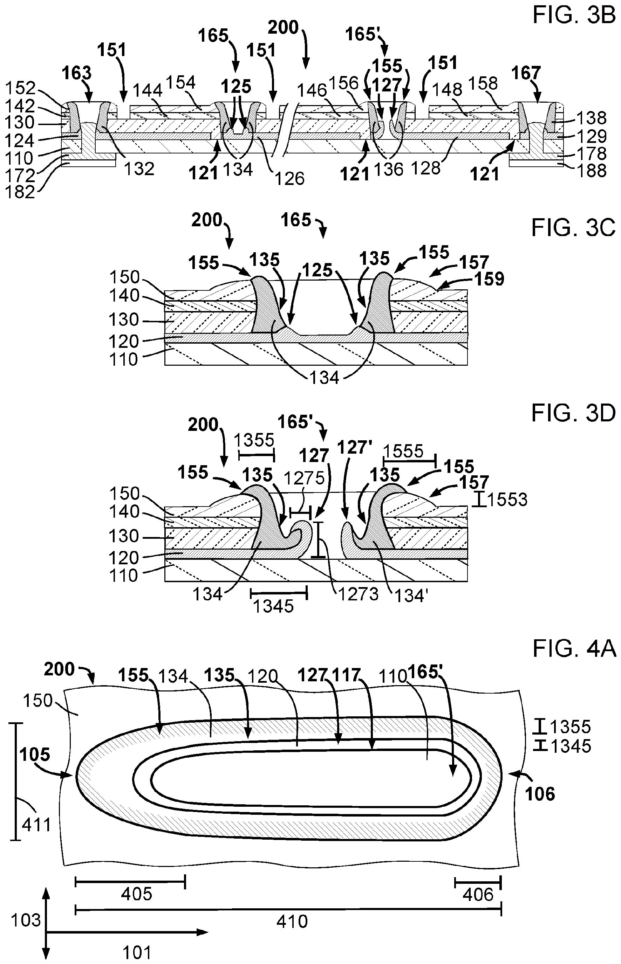

FIG. 2 show a top view of at least one laser scribing system (LSS) 2000 comprising components of the laser subsystem 1100 of FIG. 1. The LSS may be a so-called reel-to-reel system. The LSS may comprise a device transport system 2270. The device transport system (DTS) is preferably configured as a reel-to-reel system to transport a web from at least one pay-out reel assembly comprising at least one pay-out reel, thereafter called pay-out reel 2280. The pay-out reel ordinarily supplies the LSS with at least one device 200, in FIG. 2 represented as a web 200. The web comprises at least one substrate 110 (FIGS. 3B - 3D). The DTS may also comprise a pick-up reel assembly comprising at least one pick-up reel, thereafter called pick-up reel 2285. At least one of said reels 2280, 2285, is preferably configured so that the surface side of the device, or web, that is coated with scribable, thin-film, material is the side closest to the reel's axis. Said configuration is advantageous in that the coated side remains unexposed to external contact when it is rolled up on the reel. Furthermore, it is also advantageous in that it is the configuration that least stresses the material layers coating the device. Any of said reel assemblies 2280, 2285 may comprise means to adjust the tension force acting on said device, or web, as it is transported along direction 2290, for example using tension rollers (not represented). Actuation of said reel assemblies enabling transport and tensioning of said web is usually done with motors (not represented), such as stepper motors, preferably one motor at each reel. Said motors are ordinarily computer controlled, for example following a set of instructions to control the apparatus 6104 executed by the computer-based controller 6000. The pick-up reel assembly 2285 may also comprise means to avoid telescoping of the web as it is winded on the pick-up reel. Said means to avoid telescoping may comprise actuating at least one of asymmetrical tensioning control mechanisms, translating the pick-up reel along its supporting axle (not shown), and an intermediate roll (not shown).

The person skilled in the art may also consider for some scribing purposes to mount the device or web in an upside down configuration so that it is laser scribed from the substrate side. Said upside down configuration may be advantageous to scribe substrates that are only back-contact coated so as to scribe the so-called P1 scribe. The upside down configuration may also be advantageous to scribe the so-called PT scribe surrounding a device comprising all coating layers.

The LSS comprises a plurality of assemblies, preferably contained in partial or complete enclosures 2110, 2140, 2150, that comprise parts of the laser subsystem 1100 of FIG. 1. The LSS further comprises means enabling scanning of the device 200 by at least one laser beam. Said scanning means may comprise means to transport at least one scanner lens 1152 over the surface of the device 200. Said means to transport may for example comprise at least one rail 2260, 2265. FIG.2 presents an embodiment comprising a plurality of rails: a transverse rail 2260 providing means to transport at least the scanner lens 1152 across the device's transverse axis, and two longitudinal rails 2265 supporting the transverse rail 2260 and therefore providing means to transport at least the scanner lens along the device's longitudinal axis. Using actuating means the scanner lens may therefore describe two-dimensional paths over at least a portion of the device.

In one embodiment, the laser source enclosure (LSE) 2110 may for example comprise at least one laser source 1110, 1120. In another embodiment, said enclosure may also further comprise any of the components described in FIG. 1 and may preferably comprise at least one or more of: a collimator 1112, 1122; a polarizing filter 1113, 1123; a beam shaper 1114; a mirror assembly 1115, 1116, 1125, 1126; and a beam combiner 1130. Said enclosure, because of the weight of the light sources it encloses, is preferably rigidly mounted to the LSS, for example to a chassis. The transverse rail 2260 may comprise at least one rail mirror enclosure (RME) 2140. The transverse rail 2260 may also comprise at least one scribing head enclosure (SHE) 2150. In one embodiment, the RME may for example comprise at least one reflective device 1135, 1145, 1150 providing means to reflect light from the LSE towards at least one SHE 2150. The RME is preferably rigidly mounted to the transverse rail and may therefore be translated along the longitudinal axis of the LSS. The transverse rail 2260 may comprise means for translation, preferably actuated translation, of the at least one SHE. Actuated translation of the SHE along the transverse rail therefore provides at least one means for scanning of at least one laser beam 1111, 1121 onto at least one device 200. The SHE may for example comprise at least one scanner lens 1152. The SHE preferably comprises means to scan at least one laser beam 1111, 1121 onto at least one device 200. Said means to scan may for example comprise at least one or more optical devices, such as at least one mirror 1150, 1151. Means to scan by transporting the SHE along the transverse rail 2260 may comprise components of electromechanical or pneumatic devices, such as at least one component of a motor. Said motor may be rotatory or linear. In one embodiment of the LSS, the spot of at least one laser may therefore be moved at the surface of the device using cartesian motion conferred by moving the SHE along transverse rail 2260 and longitudinal rails 2265, and at least one of pan and tilt motion conferred by at least one of the scanner mirrors 1150, 1151.

In a further embodiment, the LSS comprises at least one device vacuum support 2240, the width of which is greater than that of the device or web. One purpose for the device vacuum support is to serve as a web tensioning device. In one embodiment said device vacuum support may be a roller. In another embodiment the device vacuum support may be a vacuum chuck capable of, in a first setting, sucking the web prior to laser scribing a portion of the web to ensure its flatness and then, in a second setting, not sucking or blowing air after laser scribing a portion of the web to enable advancement of the web. In another embodiment, the device vacuum support may be a moderately curved plate comprising a plurality of air blowing holes forming an air cushion between the plate and the web, thereby enabling web tension and continuous motion of the web. In yet another embodiment said device vacuum support 2240 may further incorporate through substrate lighting means 1245.

In a further embodiment, the LSS comprises means to remove and clean dust particles such as those generated by laser scribing processes. Said means comprises a first airflow device 2243 positioned across the web on the pay-out reel side of the LSS with respect to location of the scanner lens 1152 or SHE 2150. The first airflow device is preferably configured to supply air. Said means further comprises a similar second airflow device 2247 on the pick up reel side of the LSS with respect to location of the scanner lens 1152 or SHE 2150. The second airflow device is preferably configured to suck air. Said airflow devices are positioned at a distance from about 3 mm to about 20 mm, preferably about 5 mm from the web. Said airflow devices comprise a suction or blowing slot ordinarily located at a longitudinal distance from about 2 cm to about 50 cm, preferably about 20 cm away from the perimeter of the laser's working area. A transparent window 2245 is positioned between the first and the second airflow devices 2243, 2247, thereby contributing to form a duct for the passage of air which also allows passage of laser light to scribe the web. Said transparent window is positioned at a distance from about 5 mm to about 50 mm, preferably from about 20 mm to about 30 mm from the web. The person skilled in the art will infer that said transparent window need not be transparent over its entire surface but only on the surface corresponding to the laser's working area.

In yet a further embodiment, the LSS comprises an I-V (current versus voltage) measurement subsystem (IVMS) 2250. The IVMS comprises an illumination source and actuated electrical probes configured to contact designated locations on the device so as to measure it photovoltaic characteristics when subject to the IVMS's ilumination. The IVMS may further comprise means to regulate and measure the device's temperature.

FIG. 3A shows a schematic top or plan view, or view of the light exposed side, of the thin-film CIGS module 200 comprising a plurality of line segment via holes 163, 165, 165', 167, with alternate orientations, the cross-section of which is shown in FIG. 2. Lines 210 of line segment via holes 163, 165' have been scribed in direction 101 and line segment via holes 165, 167 have been scribed in the reverse direction 102. A direction that is orthogonal 103 to the direction 101, 102 in which the line segment via holes are scribed is also represented. The direction of scribing is recognizable in that the extremity corresponding to the beginning of drilling 105 of a line segment via hole has a radius of curvature that is smaller than at the end extremity 106. The length and shape of the extremity corresponding to the beginning of drilling 105 is the result of laser motion and progressive laser power increase. Progressive laser power increase is preferred to produce the conductive CIGS-type alloy while minimizing the risk for unwanted cracks and delaminations that are frequently produced when using pulsed lasers. For some laser scribing parameters and thin-film CIGS devices, the direction of scribing may also be recognized in that the extremity corresponding to the beginning of drilling 105 has a more elongated inner surface 135 of CIGS-type wall 132, 134, 136, 138 than at the extremity corresponding to the end of drilling 106. Line segment via holes 163, 165, 165', 167 may also be characterized in that a portion of the via hole length at the extremity corresponding to the beginning of drilling 105 is narrower than the average width of the via hole, excluding the portion at end extremity 106. Line segment via hole 165' is also illustrated with a top view of the gutter-shaped curl-up 127 or 127' of back-contact layer component 128 and the visible portion of substrate 110. Front-contact layer grooves 151 reveal portions of absorber layer 130. Front-contact layer grooves 151 that separate front-contact components can be manufactured at the same production step as that used for manufacturing line segment via holes, thereby advantageously reducing production complexity, time, costs, and number of tools.

Although line segment via holes may be scribed in any direction, it may be advantageous for increased manufacturing speed to scribe a first line of line segment via holes in a first direction 101 and then a second line of line segment via holes, such as an adjacent line, in a second and opposite direction 102. Furthermore, line segment via holes may be of different variations, as presented in the description for FIGS. 3A-3D and FIG. 4A, different dimensions, such as length and/or width, and have different separations whether between line segment via holes on a given line or between lines of line segment via holes.

FIG. 3B shows a cross-section of a thin-film CIGS photovoltaic module 200 comprising a plurality of line segment via holes 163, 165, 165', 167. Line segment via holes 165 enable series, monolithic interconnects between adjacent cells of the photovoltaic module. Line segment via holes 163, 167 enable electrical interconnection of front-contact or back-contact layer components to an underlying busbar 182, 188. At least one line segment via hole 163, 165, 165', 167, comprises a copper-rich CIGS-type wall 132, 134, 136, 138 resulting from heat-induced transformation of the CIGS material of the absorber layer, as described for at least one of FIGS. 3C-3D, and at least one raised portion 125, 127, of back-contact layer. Any one of said via holes 163, 165, 165', 167 may optionally comprise at least one raised portion of CIGS-type alloy 155 formed over a front-contact layer component 156 as also shown in FIGS. 3C-3D. Any one via hole 163, 165, 165', 167 may optionally comprise at least one back-contact layer component 128 formed with a gutter-shaped curl-up 127, 127' as also shown in FIG. 3D.

Photovoltaic module 200 comprises at least one electrically insulating substrate 110, at least one electrically conductive back-contact layer, here represented by back-contact layer components 124, 126, 128, 129, at least one absorber layer 130, optionally at least one buffer layer, here represented by buffer layer components 142, 144, 146, 148, and at least one electrically conductive front-contact layer, here represented by front-contact layer components 152, 154, 156, 158. Back-contact layer grooves 121 that form the electrically separate back-contact layer components are ordinarily laser scribed prior to deposition of the absorber layer. Front-contact layer grooves 151 that at least form the electrically separate front-contact layer components are ordinarily laser scribed, preferably with a pulsed laser, more preferably with a picosecond pulsed laser, and said grooves may extend in depth to the surface of said back-contact layer components.

Line segment via holes 165 establish a monolithic interconnect between at least one first front-contact layer component 154, 156, and at least one second back-contact layer component 126, 128. Said via holes may be scribed before, after, or at the same time as scribing of the front-contact layer grooves 151. Furthermore, the same laser source may be used to scribe via holes 165 and front-contact layer grooves 151.

Line segment via holes 163, 167 enable electrical contact to at least one busbar 182, 188. Via holes 163, 167 may be scribed deeper than via holes 165, 165', so as to ablate a portion of substrate 110. A conductive paste 172, 178, may be used to establish an electrical path between thin-film layers of via holes 163, 167, and busbars 182, 188, respectively. Said conductive paste may also be used as a filler in at least one via hole 163, 165, 165', 167 to augment the conductivity of the connection provided by the inner-surface 132, 134, 136, 138 within said via hole 163, 165, 165', 167.

FIGS. 3C and 3D depict two exemplary embodiments of devices manufactured using the apparatus of the disclosure provided herein, each figure being representative of a technical variation of how the method of forming line segment via holes is performed for forming monolithically-integrated optoelectronic modules. Someone skilled in the art will appreciate that the scales of the various components represented in the figures have been adjusted to improve clarity, and thus are not intended to be limiting as to the scope of the invention provided herein. Furthermore, the number and areas of components in the figures are schematically shown and thus may be further adjusted or adapted to form an industrial production worthy monolithically-integrated optoelectronic module.

FIG. 3C shows a cross-section of a portion of thin-film device 100 where a line segment via hole 165 has been scribed, preferably using a laser. The thin-film device comprises at least one electrically insulating substrate 110, at least one electrically conductive back-contact layer 120, at least one absorber layer 130, optionally at least one buffer layer 140, and at least one electrically conductive front-contact layer 150.

The electrically insulating substrate 110 may be rigid or flexible and be of a variety of materials or coated materials such as glass, coated metal, plastic-coated metal, plastic, coated plastic, such as metal-coated plastic, or flexible glass. A preferred flexible substrate material is polyimide as it is very flexible, sustains temperatures required to manufacture high efficiency optoelectronic devices, requires less processing than coated metal substrates, and exhibits thermal expansion coefficients that are compatible with those of photovoltaic material layers deposited upon it. Industrially available polyimide substrates are ordinarily available in thicknesses ranging from 7 µm to 150 µm, can sustain temperatures of about 400-600°C, and permit roll-to-roll production.

At least one electrically conductive back-contact layer 120 coats substrate 110. Back-contact layer 120 preferably has a high optical reflectance and is commonly made of molybdenum (Mo) although several other thin-film materials, such as metal chalcogenides, molybdenum chalcogenides, molybdenum selenides (such as MoSe₂), sodium (Na)-doped Mo, potassium (K)-doped Mo, Na- and K-doped Mo, transition metal chalcogenides, tin-doped indium oxide (ITO), doped or non-doped indium oxides, doped or non-doped zinc oxides, zirconium nitrides, tin oxides, titanium nitrides, titanium (Ti), tungsten (W), tantalum (Ta), gold (Au), silver (Ag), copper (Cu), and niobium (Nb) may also be used or included advantageously.

At least one absorber layer 130 coats electrically conductive layer 120. Absorber layer 130 is typically made of an ABC material, wherein A represents elements in group 11 of the periodic table of chemical elements as defined by the International Union of Pure and Applied Chemistry including copper (Cu) or silver (Ag), B represents elements in group 13 of the periodic table including indium (In), gallium (Ga), or aluminum (Al), and C represents elements in group 16 of the periodic table including sulfur (S), selenium (Se) or tellurium (Te). An example of an ABC material, as an ABC₂ material, is the Cu(In,Ga)Se₂ semiconductor also known as CIGS.

Optionally, at least one semiconductive buffer layer 140 coats absorber layer 130. Said buffer layer ordinarily has an energy bandgap higher than 1.5 eV and is for example made of CdS, Cd(S,OH), CdZnS, indium sulfides, zinc sulfides, gallium selenides, indium selenides, compounds of (indium, gallium)-sulfur, compounds of (indium, gallium)-selenium, tin oxides, zinc oxides, Zn(Mg,O)S, Zn(O,S) material, or variations thereof.

At least one transparent conductive layer 150 coats buffer layer 140. Said transparent conductive layer, also known as the front-contact, ordinarily comprises a transparent conductive oxide (TCO) layer, for example made of doped or non-doped variations of materials such as indium oxides, tin oxides, or zinc oxides.

Line segment via hole 165 is a thin-film microstructure ordinarily formed after depositing front-contact layer 150. Line segment via hole 165 is preferably scribed using at least one laser, preferably at least one continuous wave laser, so that local heat caused by scribing causes the CIGS material at the level of the CIGS absorber layer 130 lining the inner-surface of said line segment via hole 165 to permanently become electrically conductive, thereby forming CIGS-type wall 134. The material of CIGS-type wall 134 results from a local, heat-induced transformation of the CIGS material of absorber layer 130. The heat-induced transformation can be described as a partial melt and partial vaporization of the chemical components of the CIGS material, thereby resulting in CIGS-type wall 134 being formed of a copper-rich CIGS-type alloy.

A person skilled in the art may observe and quantify the thin-film microstructures and the distribution of materials using scanning electron microscopy, energy-dispersive X-ray spectroscopy (EDS), and image-processing software. Energy-dispersive X-ray spectroscopy (EDS) characterization of the copper-rich CIGS-type alloy suggests it comprises at least copper-selenide and copper.

Said CIGS-type alloy therefore forms a metalized CIGS-type wall 134 of line segment via hole 165. The metalized CIGS-type wall 134 extends within line segment via hole 165 in the direction of thin-film thickness from the back-contact layer 120 to at least front-contact layer 150. The metalized CIGS-type wall 134 therefore provides an electrically conductive path between back-contact layer 120 and front-contact layer 150. The resistivity of CIGS-type wall 134 is ordinarily in a range between that of copper, that has a resistivity of about 1.68 × 10⁻⁸ Ω.m, and about 2 × 10⁻² Ω.m, with satisfactory values within a range of about 1.9 × 10⁻³ Ω.m to 2.1 × 10⁻³ Ω.m.

Therefore, by controlling the energy delivered during a laser scribing process, a segmented via hole 165 can be desirably formed. Local heat generated by the scribing process, preferably using at least one laser, preferably at least one continuous wave laser, also causes forming of at least one raised portion 125 of back-contact layer 120 raising towards the front-contact layer 150. The raised portion 125 may provide improved mechanical and electrical contact with CIGS-type wall 134.

Furthermore, local heat generated by the scribing process may optionally cause forming of a raised portion of CIGS-type alloy 155 to at least partially cover the surface of front-contact layer 150. The raised portion of CIGS-type alloy ordinarily causes a bump of front-contact raised portion 157 along most of the via hole's periphery. Said bump of front-contact raised portion 157 may blend with the raised portion of CIGS-type alloy 155 and, towards the outer side, may either blend progressively or form an obtuse angle joint 159 with the front-contact layer. The cross-section of the outer side of the bump may for example be modeled by an optionally truncated bump function: y = exp(-1/(1-x²)) for |x| < 1 (or |x| << 1 if truncated), y = 0 otherwise. Said front-contact raised portion 157 may comprise indium diffused from the underlying absorber layer 130. Said indium may be present as a result of both heat radiating and diffusing from the location where laser energy is applied and from heat radiating from a hot plate effect caused by the presence of the underlying back-contact layer 120 during the laser scribing process, therefore causing indium to diffuse from the absorber layer 130 into the front-contact layer 150.

FIG. 3D shows a cross-section of a variation of FIG. 3C, where a portion of substrate 110 is exposed within the via hole 165' and at least one raised portion of back-contact layer 120 forms a gutter-shaped curl-up 127, 127' at the periphery 117 of the exposed portion of the substrate. Exposing substrate 110 and forming gutter-shaped curl-up 127, 127' of the back-contact layer 120 may confer larger laser scribing manufacturing window, greater production yield, and mechanical resistance than the embodiment presented in FIG. 3C. FIG. 3D presents two variations of CIGS-type walls 134, 134' and corresponding raised portions of the gutter-shaped curl-ups 127, 127' of back-contact layer 120. Variation in CIGS-type wall 134 and back-contact raised portion of the gutter-shaped curl-ups 127 is characterized in that its raised portion curls up and curls backwards, thereby forming a curl-up-and-back 127 type of curl-up, thereby surrounding and possibly blending locally with material of inner-surface 134 to form a non-homogeneous compound comprising copper, copper selenide, and molybdenum. Variation in inner-surface 134' and back-contact raised portion of the gutter-shaped curl-up 127' is characterized in that raised portion curls up but does not curl backwards, thereby forming a curl-up-only 127' type of curl-up, and comprises less blending of materials than in the curl-up-and-back 127.

The two CIGS-type wall variations 134, 134' and raised portions of the gutter-shaped curl-up 127, 127' may be present in separate via holes or in the same via hole. For example, at least one portion of one long side of a via hole 165' may be representative of variations 134, 127 while at least one portion of the other long side may be representative of variations 134', 127'. Compared to FIG. 3C, forming of the raised portion of the gutter-shaped curl-up 127, 127' of the back-contact layer 120 may in some embodiments result in a comparatively higher raising of inner-surface 134, 134' as raised portions of CIGS-type alloy 155 and also raising of front-contact raised portion 157.

Gutter-shaped curl-ups 127, 127' may be advantageous for increased via hole conductivity and strength against thin-film layer delamination. In effect, gutter-shaped curl-ups 127, 127' form welds, ordinarily comprising a non-homogeneous distribution of molybdenum, copper, and possibly copper-selenide, which locally reinforce the binding of thin-film layers to each other, especially the binding of the nearby non-molten CIGS semiconductive optoelectronically active layer to the back-contact molybdenum layer. Via holes or monolithically interconnecting grooves manufactured according to prior art, especially those manufactured using pulsed lasers instead of continuous wave lasers, may exhibit less mechanical strength, ordinarily recognizable by delaminations, flaking, and cracks in the thin-film layers of the photovoltaic devices.

Forming of variations 134, 127 and 134', 127' may be advantageous to design local adaptations of the conductivity of a via hole segment or, if the via hole segment is long enough, local adaptations of the conductivity along the length of a via hole segment by varying the height 1273 and width 1275 of the curl-up, the width of copper-rich CIGS-type alloy 1345, the width of the lip of conductive CIGS-type alloy 1355, and the amount of indium diffused into the bump-shaped raised portion 157 of the front-contact 150. For example, it may be advantageous in one embodiment to have one side of a via hole segment, such as the side that is closest to most of a cell's light exposed front-contact area, to be more conductive than the other side, such as the side that is closest to the front-contact layer grooves 151 (shown in FIG. 3A and 3B). It may also be advantageous to tailor the conductivity of the sides of a via segment so as to present a compatibility with variations in local conductivity at a cell's surface, such as variations afforded by the presence, proximity, or adjoining of front-contact conductive grid components. An embodiment may for example comprise via hole segments of various lengths, possibly via hole segments describing curves, where any one of the sides of any one of the via segments comprises a combination of variations 134, 127 and 134', 127'.

A method to manufacture at least one via hole line segment that comprises at least one of said variations may comprise using a laser spot where, when considering the laser's spot diagram at the surface of the device to be laser scribed, the region of highest laser light intensity of the laser spot is not located symmetrically with respect to the center of the laser's spot diagram. Asymmetry of the laser's spot diagram may for example be obtained by adjustments of a laser beam shaper or a laser beam expander positioned within the laser beam's optical path. By selecting or controlling the position of the region of highest laser intensity within the laser spot, a person skilled in the art may select or control the formation of curl-up variations 127 and 127'. A person skilled in the art may also desirably vary the position of the region of highest laser intensity within the laser spot so as to vary the forming of line segment via holes, such as for forming a plurality of gutter-shaped curl-ups of varied characteristics within at least one line segment via hole.

FIG. 4A shows a top view, or view of the light exposed side, of an embodiment of a line segment via hole 165' and FIG. 4B is a graph of the corresponding laser power 400 used to laser scribe the line segment via hole. Line segment via hole 165' is laser scribed into thin-film device 100 in direction 101. In FIG. 4A the laser power used forms a via hole comprising a raised, gutter-shaped curl-up 127 of the back-contact layer 120 at the periphery 117 of the exposed portion of substrate. Curl-up 127 may comprise portions of curl-up variations curl-up-and-back 127 or curl-up-only 127' shown in FIG. 3D. The underlying substrate 110 is also visible as a result of the partial ablation of the back-contact layer 120. FIG. 4A also illustrates a CIGS-type wall 155 covering a portion of front-contact layer 150. Also visible in FIG. 4A is, within a laser power increase distance portion 405, an inner surface 135 of CIGS-type wall 134 that is more elongated than the rest of the via hole's periphery. It is within said laser power increase distance portion 405 that follows the extremity corresponding to the beginning of drilling 105 that the portion of via hole is ordinarily narrower than the average width of the via hole, excluding end length 406 leading to end extremity 106.

The graph in FIG. 4B shows how the plot 400 of laser power versus distance ordinarily comprises a laser power increase portion 415. Said laser power increase portion starts from a power level that is within no power and a power level that does not form any scribing trace and ends with laser power at a level that enables forming any via hole segment similar to those presented in the description for FIGS. 3A-3D and 4A. The increase in laser power is ordinarily controlled via the laser's controller or the control system 6000 but may also be obtained by means of mechanical or optoelectronic shutters. The increase in laser power as a function of distance is ordinarily progressive and ordinarily shaped as a ramp or a step response of a damped first or second order system model. The laser spot ordinarily moves during said laser power increase distance portion by a distance 405. However, laser power may optionally be set to increase without motion of the laser spot. The laser power increase distance portion is ordinarily followed by a portion of constant power where the laser spot may move over any length and scribe or trace any pattern into the thin-film photovoltaic device 100, 200. Said pattern ordinarily comprises at least one line segment but may also comprise turns, a connected sequence of segments, or describe curves. Scribing of the via hole ends with a laser power decrease step 416 forming the end extremity 106 of the line segment via hole. Laser power is then reduced, ordinarily abruptly, to a level, ordinarily below ablation threshold power, that does not form any scribing of via hole, preferably any scribing trace.

To summarize, the laser power increase portion 415 forms the beginning of drilling extremity 105 whereas the laser power decrease step 416 forms the end extremity 106. The rate at which energy is supplied during laser power increase portion 415 is an important parameter to successfully form a via hole with highly conductive CIGS-type wall 134, 134' and gutter-shaped curl-up 127, 127'. Examples of some desirable laser scribing process parameters are discussed in more detail below. Too high a rate may result in layer delaminations, excessive layer ablation, and irregular via holes which may reduce photovoltaic efficiency of the overall device, contribute to flaking of thin-film layers, cause failure points, and shorten the device's lifetime. An abrupt laser power decrease step 416 will ordinarily enable forming of a successfully conductive end extremity 106. The abruptness of the laser power decrease is not a requirement but may be advantageous when the laser's output is controlled by an electronic controller or switch which may enforce a minimum duration, such as a simmer duration, between laser power outputs at a level that enables scribing.

FIG. 5 is a graph of laser power versus time where two line segment via holes are scribed in different parts of, for example, a thin-film CIGS module 200. The graph's scale is different from that in FIG. 4B. The graph illustrates a line segment via hole scribing sequence to scribe at least one line segment via hole. As illustrated by laser power plot 500, the sequence to scribe at least one line segment via hole comprises at least one laser power increase time portion 515, where laser power increases progressively to initiate scribing of a first line segment via hole. The increase in laser power as a function of time is preferably progressive and ordinarily shaped as a ramp or a step response of a damped first or second order system model. The laser power increase time portion 515 may be used to form a beginning portion that is similar in shape to that within the laser power increase distance portion 405, 415 that is illustrated in FIGS. 4A-4B. Laser power then optionally reaches a steady state. The sequence then ordinarily comprises a laser power reduction portion 516, ordinarily with an abrupt laser power decrease step, ordinarily to a laser power level that is below ablation threshold power. This is then followed by a reduced power level portion 517, which is ordinarily maintained at a level that does not form a via hole, or preferably any scribing trace. The line segment via hole scribing sequence is then repeated for as many line segments as necessary. Due to the large processing window, the laser power level, laser scribing duration, laser power increase and decrease portion duration and profiles need not be the same from one line segment via hole to another, as illustrated in FIG. 5.

Although this is not needed to manufacture line segment via holes for thin-film photovoltaic devices, a person skilled in the art who may want to tune the manufacturing process will henceforth be able to manufacture large numbers of line segment via holes at high speed and proceed to measure the specific resistance of each via hole. The person skilled in the art may also prepare and cut out portions of via holes bearing specific characteristics such as curl-up variations curl-up-and-back 127 or curl-up-only 127', height 1273 and width 1275 of the curl-up, and in-layer extent 1345 of copper-rich CIGS-type alloy so as to measure the specific resistance of the via hole portion and subsequently select the most appropriate laser spot shape and position of the region of highest laser intensity within the laser spot. A satisfactory process yields an average value for resistivity of the CIGS-type wall at 3.2 × 10³ Ω.m, more preferably at 2 × 10³ Ω.m, with standard deviation of 0.06.

As an example, the laser power increase time portion 515 using a continuous wave laser delivering a 6 W and 50 µm diameter laser spot to the device's surface lasts preferably between 10 µs and 4 us for a laser scanning speed between 3 m/s and 5 m/s, and preferably between 50 µs and 7 µs for a laser scanning speed between 0.5 m/s and 3 m/s. The corresponding laser power increase rate measured at the device's surface is therefore in the range between about 1 × 10⁸ W/m.s⁻² and 17 × 10⁸ W/m.s⁻². For a preferred laser scanning speed of about 3.7 m/s the preferred laser power increase time portion 515 lasts about 7 µs with an increase in laser power shaped as a step response of a damped first or second order system model. A preferred laser power decrease step 416 is an abrupt decrease of laser power to a level below ablation threshold power.

The laser power increase distance portion 405, 415 is ordinarily at least 5 µm in length. The portion of steady state or laser constant power may be set for a measured power of, for example, about 7 W, at the surface of the device to be scribed and a laser scanning speed of, for example, about 3.7 m/s. In this case the laser power is measured at the surface of the device to be laser scribed using a laser power meter with thermopile sensor capable of measurements from 10 µW up to 30 kW. A person skilled in the art may choose a greater laser power, possibly in combination with a greater speed of the laser scribing spot. The steady state laser power is ordinarily set for a measured power in the range from 0.2 W to 20 W, preferably from 2 W to 10 W, more preferably from 5 W to 8 W. The laser's wavelength is ordinarily in the range from 532 nm to 1064 nm. The laser scribing spot diameter is ordinarily in the range from 5 µm and 1000 µm, preferably between 5 µm and 300 µm, more preferably between 30 µm and 50 µm.

A line segment via hole scribing sequence may preferably form line segment via holes that are, for example, about 200 µm in length with an about 50 µm separation between the end extremity of a first via hole and the beginning extremity of a second via hole. Ordinarily, via hole length 410 may be in the range of 50 µm to 0.1 m, preferably in the range of 50 µm to 1000 µm, more preferably in the range of 180 µm to 220 µm, and separation in the range of 10 µm to 1000 µm, preferably in the range of 10 µm to 100 µm, more preferably in the range of 40 µm to 60 µm. A person skilled in the art may prefer to specify a scribe-to-no-scribe length ratio which may be in the range of 1:1 to 100:1, preferably 4:1. Line segment width 411, comprising the inner surface 135 of CIGS-type wall 134 and front-contact raised portion 157 covering a portion of front-contact layer 150, is ordinarily in the range of 10 µm to 100 µm, preferably in the range of 25 µm to 75 µm, more preferably in the range of 45 µm to 55 µm, for example at about 50 µm. Referring to FIG. 3D, the bump of the front-contact raised portion 157 at the surface of front-contact layer 150 has a cross-section width 1555 measured from front-contact edge near the inner surface of the CIGS-type wall to the outer blend or obtuse joint where it meets with the front-contact layer is ordinarily in the range of 3 µm to 25 µm, preferably in the range of 10 µm to 15 µm, for example at about 12 µm. The thickness 1553 of the front-contact raised portion above the front-contact layer's flat surface is in the range from 0.5 µm to 6 µm, preferably in the range of 1 µm to 3 µm, more preferably in the range 1.5 µm to 2.5 µm, for example at about 2 µm. The height 1273 of the back-contact layer gutter-shaped curl-up 127, 127', measured from the surface of substrate 110, is ordinarily in the range of 0.5 µm to 10 µm, preferably in the range of 0.5 µm to 5 µm, more preferably in the range of 2 µm to 4 µm, for example at about 3 µm.

Laser scanning speed is ordinarily in the range of 0.1 m/s to 200 m/s, preferably in the range of 0.5 m/s to 100 m/s, more preferably in the range from 0.5 m/s to 6 m/s. The energy delivered by drilling at steady state laser power ordinarily ranges from 1 J/m to 8 J/m, preferably from 1.5 J/m to 2.2 J/m. The steady state laser fluence is ordinarily in the range from 5 × 10⁸ J/m² to 41 × 10⁸ J/m², preferably from 7.5 × 10⁸ J/m² to 11 × 10⁸ J/m². Although line segment via holes are preferably scribed using a continuous wave laser, a person skilled in the art may use a pulsed laser such as a picosecond laser.

The composition of laser-scribed microstructures may be analyzed using an X-ray diffraction (XRD) analysis system. The presence of back-contact layer gutter-shaped curl-ups is characterized by at least one peak in counts in the range between 58.5 2θ° and 59.5 2θ°, preferably at 58.7 2θ°, more preferably at 58.66 2θ° corresponding to the presence of Mo with a (220) Miller index orientation. Said peak in counts is greater by at least 5% than the number of counts for thin-film CIGS devices that do not comprise vias or scribings manufactured according to embodiments of the present invention. Mo thin-film that is not curled-up ordinarily has a (111) Miller index orientation. The gutter-shaped curl-up may blend or form an alloy with molten CIGS, thereby comprising copper and especially copper-selenide with non-uniform concentrations within the curl-up.

FIG. 6 presents an embodiment for a control system 6000 that comprises a processing unit and a memory unit for executing instructions 6100. The instructions 6100 may comprise a set of instructions to acquire scribing instructions 6102, for example comprising at least one of a user interface, means to read a database, and a computer network interface. The control system 6000 may further comprise a set of instructions to extract vision data 6140. Said instructions to extract vision data 6140 may for example comprise instructions to acquire scribe images 6146 from a vision system configured to monitor the thin-film device 200 and may also comprise instructions to process the scribe images 6147. The control system 6000 may also comprise instructions to command or control at least one of the laser's power 6110. For example the control system 6000 may simultaneous command or control a plurality of lasers 1110, 1120, thereby enabling simultaneous scribing of the lines 210 of line segment via holes 163, 165, 165', 167 (also called P2 scribes) and of front contact layer grooves 151 (also called P3 scribes). The control system 6000 may further comprise instructions to command and control a plurality of components of the laser scribing apparatus 1100, 2000. For example, said instructions may comprise instruction sets to control the laser scanner 6130, for example by actuating and adjusting at least one of the components enabling laser scanning such as at least one of: the scanner mirror assemblies 1150, 1151; at least one of the scribing head enclosure's 2150 on at least one of the supporting rails 2260, 2265. The instructions 6100 may further comprise instructions to control the laser alignment 6130 with instructions to acquire photodetector data 6136 originating from the beam alignment sensor 1136 and actuating mirror assemblies 1115, 1116, 1125, 1126, 1151, 1150 and beam combiner 1130 using corresponding actuating instructions 6115, 6125. Two sets of actuating instructions 6115, 6125 are represented due to the fact that various laser types of lasers may be used, lasers beams may be adjusted with respect to each other, and may be adjusted with respect to the optics 1131, 1135, 1145, 1152 and to the thin-film device to be scribed 200. The instructions 6100 may further comprise instructions to adjust the laser spot shape 6200, for example by adjusting optical components such as the scanner lens, and optionally further instructions to adjust the laser beam shaper 6114. The instructions 6100 may therefore enable a feedback control system whereby vision data and instructions to process vision data enable adjustments to the laser scribing system's optical components, laser beams, lasers, and motion of laser beams for forming the desired line segment via holes and other scribes presented in FIGS. 3A-3D, 4A, scribing characteristics presented in FIGS. 4B and 5, and laser irradiance characteristics presented in FIGS. 7A-7G.

FIGS. 7A-7G present characteristics of laser spots on the thin-film device and their irradiance. The irradiance distribution of the laser spot is ordinarily axis-symmetrical (7200 in FIG. 7B) or symmetrical with respect to the direction of laser scribing 101, 102, 7000. A person skilled in the art may however prefer an asymmetrical irradiance distribution with respect to the direction of laser scribing 101, 102, for example to obtain asymmetrical laser scribes 165' as presented in FIG. 3D. FIG. 7A presents a set of asymmetrical irradiance distributions 7110, 7120, 7130, 7140. For example in a first configuration, a single maximum irradiance section 7110 presents an off-center maximum 7111 and therefore would exhibit an off-center centroid in the plane of the thin-film device. In a second configuration of the laser scribing system 1100, 2000, the laser spot's irradiance presents a double maximum irradiance section 7120 with a first maximum 7121 and a second maximum 7121. A third configuration 7130 may present a ramp irradiance section 7131. A fourth configuration 7140 may present a triple maximum irradiance section with a first maximum 7141, a second maximum 7142, and a third maximum 7143, said second maximum 7142 may optionally be an intermediate between the first 7141 and the third 7143.

FIG. 7C presents a circular laser spot 7300 comprising an asymmetrical irradiance distribution. FIG. 7C presents a stronger weight to the left side of the spot, therefore corresponding to irradiance distributions of FIG. 7A. FIG. 7D presents a trapezoidal laser spot 7400 comprising a long side 7410 and a short side 7420, both sides parallel to the direction of laser scribing 7000. The laser spot 7400 is illustrated with a uniform irradiance distribution but, because more energy will be transferred to the thin-film device 200 by the long side 7410 than by the short side 7420, it may enable manufacturing of asymmetrical line segment via holes 165'. FIG. 7E presents a trapezoidal laser spot with off-center irradiance centroid 7500, long side 7510 and short side 7520. FIG. 7A therefore combines features of FIG. 7A with the trapezoidal spot of FIG. 7D. Furthermore, the trapezium 7500 is tilted by an angle 7020, for example comprised between 10° and 45°, with respect to the direction of laser scribing 7000. Tilting the long side 7510 of the trapezium by angle 7020 may enable a more progressive heating of one side of the line segment via hole 165' and improved formation of curl-ups 127', 127. Tilting the long side 7510 is therefore equivalent to forming a wedge-shaped laser spot. FIG. 7F presents a rectangular-shaped laser spot 7600 with off-center irradiance centroid. FIG. 7G presents a laser spot with coma 7700. The laser spot with coma 7700 may for example be obtained by defocusing or deforming at least one of the optics used to form the laser spot, for example by defocusing the scanner lens 1152. The laser spot with coma 7700 may comprise a high irradiance area in first region of coma 7710, a low irradiance area in first region of coma 7720, a second region of coma 7730, and a thrid region of coma 7740. A laser spot with coma may therefore comprise an off-center irradiance distribution.

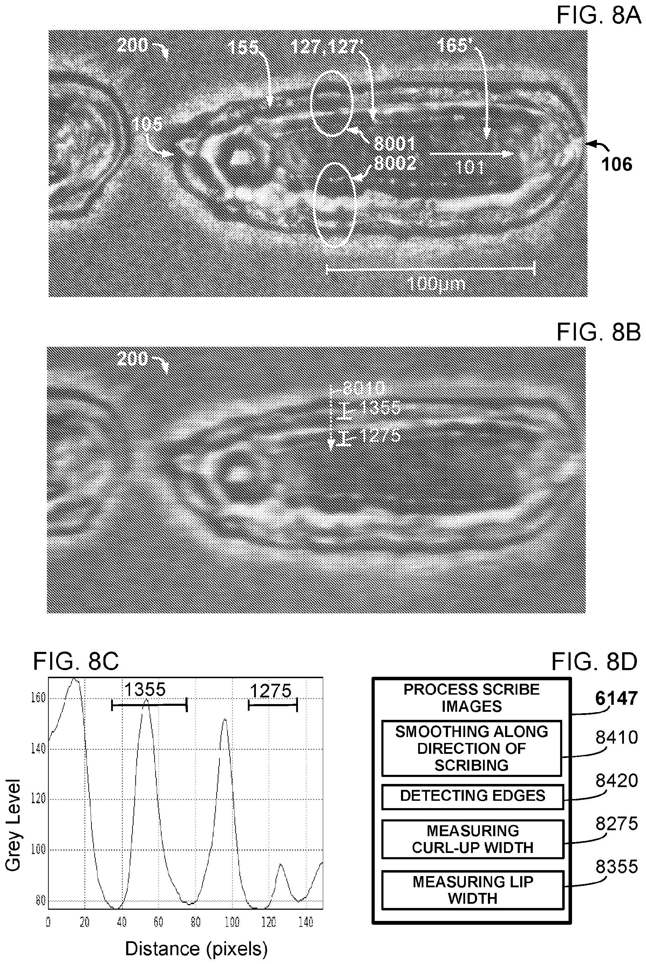

FIG. 8A presents an image of a thin-film device 200 comprising a line segment via hole 165, 165' acquired with optical monitoring means 1160, for example a microscope with a camera and at least one overhead lighting means 1243, 1244, 1246. A portion of a second line segment via hole is also visible at the left of the image. Both line segment via holes are therefore part of a line of line segment via holes 210 as presented in FIG. 3A. Highlighted in FIG. 8A are the locations of the extremity of beginning of drilling 105, the extremity of end of drilling 106, at least one location of a raised portion of CIGS-type alloy 155, and at least one location of a gutter-shaped curl-up 127, 127' of the back-contact layer component 128. The direction of scribing is therefore left to right. A person skilled in the art will notice that features of the line segment via hole 165' at the left of the scribing direction 101, highlighted in ellipse 8001, are finer those at the right of said scribing direction, highlighted in ellipse 8002. Line segment via hole 165' therefore presents an asymmetry with respect to the scribing direction 101.

Referring to FIG. 8B, a person skilled in the art may want to measure characteristics of a line segment via hole 165, 165'. For example at least one of measures of the width of the lip of conductive CIGS-type alloy 1355 and measures of the width of a curl-up 1275 of the back-contact layer 120, 124, 126, 128, 129 may provide indication that said line segment via hole is correctly formed. Said measures may for example provide a visual assessment that a satisfactory monolithic interconnect from a back-contact layer to a front-contact layer is achieved via conductive alloy resulting from a permanent change in the chemical composition of the semiconductive optoelectronically active layer where the line segment via hole is drilled. Automation of this assessment using computer vision instructions is one object of this disclosure.

FIG. 8B therefore presents FIG. 8A following digital smoothing that is greater along a direction parallel to the direction of laser scribing 101 than along the orthogonal direction. Said digital smoothing may therefore be said to be anisotropic. Digital smoothing may be obtained using at least one digital smoothing function or algorithm, for example linear smoothers, Gaussian smoothing, convolution kernels, filters, and diffusion methods. Preferred methods will therefore use an anisotropic smoothing method. FIG. 8B was for example obtained by a Gaussian smoothing operator that extends 6 times more in the direction parallel to the direction of laser scribing 101 than in the orthogonal direction.

FIG. 8C shows a plot of the grey levels along arrow 8010 in FIG. 8B. FIG. 8C highlights measures of the width of the lip of conductive CIGS-type alloy 1355 and measures of the width of a curl-up 1275 of the back-contact layer. For the width of the lip of conductive CIGS-type alloy 1355, the measure extends for example from, starting from the line segment via hole's outer edge, about the first minimum to about the second minimum. For the width of a curl-up 1275 of the back-contact layer, starting from the line segment via hole's outer edge, about the third minimum to about the fourth minimum. A person skilled in the art of computer vision may choose to adjust said measurement, for example by searching for midpoints between maximums and minimums, inflection points, or other features that may provide a metric reference. Further processing of the image data may contribute to improved or faster results. The objective is to obtain reliable measures for visual features 1275, 1355 that are indicative of the quality of a line segment via hole 165, 165' monolithic interconnect derived from conductive CIGS-type alloy.

FIG. 8D is a diagram that summarizes instructions to process scribe images 6147. Said instructions 6147 may be executed by the control system 6000 or a separate computing unit (not shown). Said instruction 6147 comprise at least instructions for smoothing along a direction of scribing 8410. The instructions 6147 may further comprise instructions for detecting edges 8420 or other feature-detecting methods. The instructions 6147 may therefore also comprise instruction for measuring curl-up width 8275 and instructions for measuring lip width 8355.

## Claims

1. A computer-controlled apparatus (1100, 2000) for laser scribing at least one line segment via hole (163, 165, 165', 167) in a thin-film device (200) that comprises on a first side of at least one substrate (110), at least:
- one front-contact layer (150, 152, 154, 156, 158);
- one semiconductive optoelectronically active layer (130);
- one back-contact layer (120, 124, 126, 128, 129);
wherein the apparatus comprising:
- at least one laser source (1110, 1120) emitting at least one laser beam (1111, 1121);
- means comprising at least one mirror (1150, 1151) that cooperates with said at least one laser beam to form at least one laser spot (7200, 7300, 7400, 7500, 7600, 7700) on the first side of said device;
- at least one actuator (1115, 1116, 1125, 1126, 1130, 1150, 1151, 2140, 2150, 2260, 2265, 2280, 2285) configured to move at least one laser spot for laser scribing the thin-film device (200) along at least one direction (101, 102) by delivering laser power (400) to said thin-film device (200);
- at least one optical sensor (1146, 1160) configured to acquire imaging data of said first side of said at least one line segment via hole (163, 165, 165', 167), and
- at least one control system (6000), comprising a processing unit and a memory unit, for executing instructions for processing said imaging data, **characterized in that** said control system is operative to execute:
- image processing instructions (6140, 6146, 6147) for measuring in the imaging data, along a direction (103) that is orthogonal to at least one direction of laser scribing (101, 102) said at least one line segment via hole (163, 165, 165', 167):
- a first characteristic of a line segment via hole, namely the width of a curl-up (1275) of the back-contact layer (120, 124, 126, 128, 129);
- a second characteristic of a line segment via hole, namely the width of a lip (1355) of conductive alloy resulting from a permanent change in the chemical composition of the semiconductive optoelectronically active layer where the line segment via hole (163, 165, 165', 167) is drilled.

2. The apparatus according to Claim 1 wherein the image processing instructions (6140, 6146, 6147) comprise instructions wherein image data in at least one portion of an image of at least one line segment via hole (163, 165, 165', 167) is smoothed and where the amount of smoothing in a direction parallel to said direction of laser scribing (101, 102) is greater than in any other direction.

3. The apparatus according to Claims 1 or 2 wherein the control system (6000) comprises instructions for adjusting at least one actuator as a function of at least one of:
- said first characteristic of a line segment via hole, namely the width of a curl-up (1275) of the back-contact layer (120, 124, 126, 128, 129);
- said second characteristic of a line segment via hole, namely the width of a lip (1355) of said conductive alloy resulting from a permanent change in the chemical composition of the semiconductive optoelectronically active layer where the line segment via hole (163, 165, 165', 167) is drilled.

4. The apparatus according to Claims 1 to 3 wherein the control system (6000) comprises means to control laser power (6110).

5. The apparatus according to any one of Claims 1 to 4 wherein, during motion of the at least one laser beam spot for drilling of the line segment via hole, the distance (410) where laser power (400) is delivered comprises at least one laser power increase distance portion (405) comprising a progressive increase in power (415).

6. The apparatus according to any one of Claims 1 to 5 wherein the control system (6000) comprises instructions (6102) to scribe at least one line (210) comprising a plurality of line segment via holes.

7. The apparatus according to any one of Claims 1 to 6 wherein said at least one laser source (1110, 1120) comprises at least a first laser source which is a continuous wave laser (1110) and at least a second laser source which is a pulsed laser (1120).

8. The apparatus according to Claim 7 wherein the continuous wave laser (1110) and the pulsed laser (1120) operate simultaneously.

9. The apparatus according to Claims 7 or 8 wherein the means to form at least one laser spot comprise at least one scanner lens (1152) wherein a continuous wave laser beam (1111) of the continuous wave laser (1110) and a pulsed laser beam (1121) of the pulsed laser (1120) pass through said scanner lens (1152).

10. The apparatus according to Claims 8 or 9 further comprising at least one beam shaper (1114) configured to adjust the shape of the continuous wave laser beam (1111).

11. The apparatus according to Claim 10 wherein the control system (6000) comprises instructions (6114) to adjust the beam shaper (1114).

12. The apparatus according to Claim 11 wherein the instructions (6114) to adjust the beam shaper (1114) comprise instructions to configure the beam shaper to produce an irradiance distribution (7110, 7120, 7130, 7140) of the at least one laser spot formed by the continuous wave laser beam (1111) that is not symmetrical with respect to an axis parallel to the direction of laser scribing (101, 102).

13. The apparatus according to any one of Claims 9 to 12 further comprising means to automatically adjust the scanner lens (1152) so that the focus of the at least one laser spots remain constant.

14. The apparatus according to any one of Claims 1 to 13 wherein the at least one actuator configured to adjust the position of at least one laser spot comprises means to adjust the angle of at least one mirror (1150, 1151).

15. The apparatus according to any one of Claims 1 to 14 wherein the at least one actuator configured to adjust the position of at least one laser spot device comprises at least one rail (2260, 2265) configured to translate said at least one mirror.

16. The apparatus according to any one of Claims 1 to 15 further comprising means (2280, 2285) to transport said thin-film device (200).

17. The apparatus according to any one of Claims 1 to 16 further comprising a device vacuum support (2240).

18. The apparatus according to any one of Claims 1 to 17 further comprising means to illuminate the layer-comprising first side of the thin-film device (200) from a first position (1243) for a first image acquisition (6146) and from a second position (1244) for a second image acquisition (6146), the first position and the second position being separated by a baseline distance (1242) along a direction that is orthogonal to said direction of scribing.

19. The apparatus according to Claims 1 to 18 further comprising at least one source of structured light (1246).

## Patentansprüche

1. Computergesteuerte Vorrichtung (1100, 2000) zum Laserschreiben mindestens eines Liniensegments von Durchgangslöchern (163, 165, 165', 165', 167) in einer Dünnschichtvorrichtung (200), die auf einer ersten Seite eines Substrats (110) mindestens umfasst:
- eine Frontkontaktschicht (150, 152, 154, 156, 158);
- eine halbleitende optoelektronisch aktive Schicht (130);
- eine Rückkontaktschicht (120, 124, 126, 128, 129);
wobei die Vorrichtung umfasst:
- mindestens eine Laserquelle (1110, 1120), die mindestens einen Laserstrahl (1111, 1121) emittiert;
- Mittel, umfassend mindestens einen Spiegel (1150, 1151), der mit dem mindestens einen Laserstrahl zusammenwirkt, um mindestens einen Laserpunkt (7200, 7300, 7400, 7500, 7500, 7600, 7700) auf der ersten Seite der Vorrichtung zu bilden;
- mindestens einen Stellantrieb (1115, 1116, 1125, 1126, 1130, 1150, 1151, 2140, 2150, 2260, 2265, 2280, 2285), der konfiguriert ist, um mindestens einen Laserpunkt zum Laserschreiben der Dünnschichtvorrichtung (200) entlang mindestens einer Richtung (101, 102) zu bewegen, indem Laserleistung (400) an die Dünnschichtvorrichtung (200) abgegeben wird;
- mindestens einen optischen Sensor (1146, 1160), der konfiguriert ist, um Bilddaten der ersten Seite des Liniensegments von Durchgangslöchern (163, 165, 165, 165', 167) zu erfassen, und
- mindestens ein Steuersystem (6000), das eine Verarbeitungseinheit und eine Speichereinheit umfasst, zum Ausführen von Anweisungen zum Verarbeiten der Bilddaten, **dadurch gekennzeichnet, dass** das Steuersystem zum Ausführen wirksam ist:
- Bildverarbeitungsanweisungen (6140, 6146, 6147) um Messungen innerhalb der der Bilddaten entlang einer Richtung (103), die orthogonal zu mindestens einer Richtung des Laserschreibens (101, 102) ist, durchzuführen, wobei das Liniensegment von Durchgangslöchern (163, 165, 165, 165', 167) verläuft:
- ein erstes Merkmal eines Liniensegments von Durchgangslöchern, nämlich die Breite eines Aufrollens (1275) der Rückkontaktschicht (120, 124, 126, 128, 129);
- ein zweites Merkmal eines Liniensegments von Durchgangslöchern, nämlich die Breite einer Lippe (1355) aus einer leitfähigen Legierung, die sich aus einer permanenten Änderung der chemischen Zusammensetzung der halbleitenden optoelektronisch aktiven Schicht ergibt, wo das Liniensegment von Durchgangslöchern (163, 165, 165, 165', 167) gebohrt wird.

2. Vorrichtung nach Anspruch 1, wobei die Bildverarbeitungsanweisungen (6140, 6146, 6147) Anweisungen umfassen, bei denen Bilddaten in mindestens einem Abschnitt eines Bildes von mindestens einem Liniensegment von Durchgangslöchern (163, 165, 165', 167) geglättet werden und wobei der Glättungsbetrag in einer Richtung parallel zu der Richtung des Laserschreibens (101, 102) größer ist als in jeder anderen Richtung.

3. Die Vorrichtung nach Anspruch 1 oder 2, worin das Steuersystem (6000) Anweisungen zum Einstellen mindestens eines Stellglieds in Abhängigkeit von mindestens einem der folgenden umfasst:
- das erste Merkmal eines Liniensegments von Durchgangslöchern, nämlich die Breite eines Aufrollens (1275) der Rückkontaktschicht (120, 124, 126, 126, 128, 129);
- das zweite Merkmal eines Liniensegments von Durchgangslöchern, nämlich die Breite einer Lippe (1355) der leitenden Legierung, die sich aus einer permanenten Änderung der chemischen Zusammensetzung der halbleitenden optoelektronisch aktiven Schicht ergibt, wo das Liniensegment von Durchgangslöchern (163, 165, 165, 165', 167) gebohrt wird.

4. Die Vorrichtung nach den Ansprüchen 1 bis 3, wobei das Steuersystem (6000) Mittel zum Steuern der Laserleistung (6110) umfasst.

5. Vorrichtung nach einem der Ansprüche 1 bis 4, wobei während der Bewegung mindestens eines Laserstrahlpunkts zum Bohren des Leitungssegments von Durchgangslöchern der Abstand (410), wo die Laserleistung (400) abgegeben wird, mindestens einen Laserleistungserhöhungsabstandabschnitt (405) umfasst, der eine progressive Leistungssteigerung (415) umfasst.

6. Die Vorrichtung nach einem der Ansprüche 1 bis 5, worin das Steuersystem (6000) Anweisungen (6102) zum Schreiben mindestens einer Linie (210) umfasst, die eine Vielzahl von Liniensegmenten von Durchgangslöchern umfasst.

7. Vorrichtung nach einem der Ansprüche 1 bis 6, wobei mindestens eine Laserquelle (1110, 1120) mindestens eine erste Laserquelle umfasst, die ein Dauerstrichlaser (1110) ist, und mindestens eine zweite Laserquelle, die ein gepulster Laser (1120) ist.

8. Vorrichtung nach Anspruch 7, wobei der Dauerstrichlaser (1110) und der gepulste Laser (1120) gleichzeitig arbeiten.

9. Die Vorrichtung nach Anspruch 7 oder 8, wobei die Mittel zum Bilden mindestens eines Laserflecks mindestens eine Scannerlinse (1152) umfassen, wobei ein dauerstrich Laserstrahl (1111) des Dauerstrichlaserns (1110) und ein gepulster Laserstrahl (1121) des gepulsten Lasers (1120) die Scannerlinse (1152) durchlaufen.

10. Die Vorrichtung nach den Ansprüchen 8 oder 9 ferner umfassend mindestens einen Strahlformer (1114), der konfiguriert ist, um die Form des dauerstrich Laserstrahls (1111) anzupassen.

11. Die Vorrichtung nach Anspruch 10, wobei das Steuersystem (6000) Anweisungen (6114) zum Einstellen des Strahlformers (1114) umfasst.

12. Die Vorrichtung nach Anspruch 11, wobei die Anweisungen (6114) zum Einstellen des Strahlformers (1114) Anweisungen zum Konfigurieren des Strahlformers zum Erzeugen einer Bestrahlungsverteilung (7110, 7120, 7130, 7140) mindestens eines Laserflecks umfassen, der durch den dauerstrich Laserstrahl (1111) gebildet wird, der nicht symmetrisch in Bezug auf eine Achse parallel zur Richtung des Laserschreibens (101, 102) ist.

13. Die Vorrichtung nach einem der Ansprüche 9 bis 12 umfassend ferner Mittel zum automatischen Einstellen der Scannerlinse (1152), so dass der Fokus der mindestens einen Laserpunkte konstant bleibt.

14. Die Vorrichtung nach einem der Ansprüche 1 bis 13, wobei mindestens ein Stellglied, das zum Einstellen der Position mindestens eines Laserpunktes konfiguriert ist, Mittel zum Einstellen des Winkels mindestens eines Spiegels (1150, 1151) umfasst.

15. Die Vorrichtung nach einem der Ansprüche 1 bis 14, wobei mindestens ein Stellglied, das zum Einstellen der Position mindestens einer Laserpunktvorrichtung konfiguriert ist, mindestens eine Schiene (2260, 2265) umfasst, die zum Verschieben des mindestens einen Spiegels konfiguriert ist.

16. Die Vorrichtung nach einem der Ansprüche 1 bis 15 umfassend ferner Mittel (2280, 2285) zum Transportieren der Dünnschichtvorrichtung (200).

17. Die Vorrichtung nach einem der Ansprüche 1 bis 16 umfassend ferner einen Vorrichtungsvakuumträger (2240).

18. Die Vorrichtung nach einem der Ansprüche 1 bis 17 umfassend ferner Mittel zum Beleuchten der Schicht, die die erste Seite der Dünnschichtvorrichtung (200) umfasst, von einer ersten Position (1243) für eine erste Bildaufnahme (6146) und von einer zweiten Position (1244) für eine zweite Bildaufnahme (6146), wobei die erste Position und die zweite Position durch einen Basisabstand (1242) entlang einer Richtung getrennt sind, die orthogonal zu der Richtung des Schreibens ist.

19. Die Vorrichtung nach den Ansprüchen 1 bis 18 umfassend ferner mindestens eine Quelle für strukturiertes Licht (1246).

## Revendications

1. Appareil commandé par ordinateur (1100, 2000) pour tracer au laser au moins un segment de ligne de trous de passage (163, 165, 165, 165', 167) dans un dispositif à couche mince (200) qui comprend sur un premier côté d'au moins un substrat (110), au moins :
- une couche de contact avant (150, 152, 154, 156, 158) ;
- une couche semi-conductrice optoélectroniquement active (130) ;
- une couche de contact arrière (120, 124, 126, 128, 129) ;
où l'appareil comprend :
- au moins une source laser (1110, 1120) émettant au moins un faisceau laser (1111, 1121) ;
- des moyens comprenant au moins un miroir (1150, 1151) qui coopère avec ledit au moins un faisceau laser pour former au moins un spot laser (7200, 7300, 7400, 7500, 7600, 7700) du premier côté dudit dispositif ;
- au moins un actionneur (1115, 1116, 1125, 1126, 1130, 1150, 1151, 2140, 2150, 2260, 2265, 2280, 2285) configuré pour déplacer au moins un spot laser pour tracer au laser le dispositif à couche mince (200) dans au moins une direction (101, 102) en fournissant une puissance laser (400) audit dispositif à couche mince (200) ;
- au moins un capteur optique (1146, 1160) configuré pour acquérir des données d'imagerie dudit premier côté dudit au moins segment de ligne de trous de passage (163, 165, 165', 167), et
- au moins un système de commande (6000), comprenant une unité de traitement et une unité de mémoire, pour exécuter des instructions pour traiter lesdites données d'imagerie, **caractérisé en ce que** ledit système de commande est opérationnel pour exécuter :
- des instructions de traitement d'image (6140, 6146, 6147) pour mesurer dans les données d'imagerie, le long d'une direction (103) qui est orthogonale à au moins une direction de traçage laser (101, 102) dudit au moins segment de ligne de trous de passage (163, 165, 165', 167) :
- une première caractéristique d'un segment de ligne de trous de passage, à savoir la largeur d'une courbure (1275) de la couche de contact arrière (120, 124, 126, 128, 129) ;
- une deuxième caractéristique d'un segment de ligne de trous de passage, à savoir la largeur d'un rebord (1355) d'un alliage conducteur résultant d'une modification permanente de la composition chimique de la couche semi-conductrice optoélectroniquement active où le segment de ligne de trous de passage (163, 165, 165', 167) est foré.

2. Appareil selon la revendication 1, dans lequel les instructions de traitement d'image (6140, 6146, 6147) comprennent des instructions dans lesquelles des données d'image dans au moins une partie d'une image d'au moins un segment de ligne de trous de passage (163, 165, 165', 167) sont lissées et où la quantité de lissage dans une direction parallèle à ladite direction du marquage par laser (101, 102) est supérieure à toute autre direction.

3. Appareil selon les revendications 1 ou 2, dans lequel le système de commande (6000) comprend des instructions pour régler au moins un actionneur en fonction d'au moins un des éléments suivants :
- ladite première caractéristique d'un segment de ligne de trous de passage, à savoir la largeur d'une courbure (1275) de la couche de contact arrière (120, 124, 126, 128, 129) ;
- ladite seconde caractéristique d'un segment de ligne de trous de passage, à savoir la largeur d'un rebord (1355) dudit alliage conducteur résultant d'un changement permanent dans la composition chimique de la couche optoélectroniquement active semi-conductrice où le segment de ligne de trous de passage (163, 165, 165', 167) est foré.

4. Appareil selon les revendications 1 à 3, dans lequel le système de commande (6000) comprend des moyens pour commander la puissance laser (6110).

5. Appareil selon l'une quelconque des revendications 1 à 4, dans lequel, pendant le déplacement du au moins un spot de faisceau laser pour percer le segment de ligne de trous de passage, la distance (410) où la puissance laser (400) est délivrée comprend au moins une partie de distance (405) pour augmenter la puissance laser comprenant une augmentation progressive de la puissance (415).

6. Appareil selon l'une quelconque des revendications 1 à 5, dans lequel le système de commande (6000) comprend des instructions (6102) pour tracer au moins une ligne (210) comprenant une pluralité de segments de ligne de trous de passage.

7. Appareil selon l'une quelconque des revendications 1 à 6, dans lequel ladite au moins une source laser (1110, 1120) comprend au moins une première source laser qui est un laser à ondes continues (1110) et au moins une seconde source laser qui est un laser pulsé (1120).

8. Appareil selon la revendication 7, dans lequel le laser à ondes continues (1110) et le laser pulsé (1120) fonctionnent simultanément.

9. Appareil selon les revendications 7 ou 8, dans lequel les moyens pour former au moins un spot laser comprennent au moins une lentille de balayage (1152) dans laquelle un faisceau laser à onde continue (1111) du laser à onde continue (1110) et un faisceau laser pulsé (1121) du laser pulsé (1120) passent par ladite lentille de balayage (1152).

10. Appareil selon les revendications 8 ou 9 comprenant en outre au moins un façonneur de faisceau (1114) configuré pour ajuster la forme du faisceau laser à onde continue (1111).

11. Appareil selon la revendication 10, dans lequel le système de commande (6000) comprend des instructions (6114) pour ajuster le façonneur de faisceau (1114).

12. Appareil selon la revendication 11, dans lequel les instructions (6114) d'ajustement du façonneur de faisceau (1114) comprennent des instructions pour configurer le façonneur de faisceau afin de produire une distribution d'irradiance (7110, 7120, 7130, 7140) du au moins un spot laser formé par le faisceau laser à onde continue (1111) qui n'est pas symétrique par rapport à un axe parallèle à la direction du marquage au laser (101, 102).

13. L'appareil selon l'une quelconque des revendications 9 à 12 comprenant en outre des moyens pour ajuster automatiquement la lentille de balayage (1152) de sorte que le point focal des au moins un spot laser reste constant.

14. Appareil selon l'une quelconque des revendications 1 à 13, dans lequel le au moins un actionneur configuré pour ajuster la position d'au moins un spot laser comprend un moyen pour ajuster l'angle d'au moins un miroir (1150, 1151).

15. Appareil selon l'une quelconque des revendications 1 à 14, dans lequel le au moins un actionneur configuré pour ajuster la position d'au moins un dispositif de spot laser comprend au moins un rail (2260, 2265) configuré pour déplacer ledit au moins un miroir.

16. Appareil selon l'une quelconque des revendications 1 à 15 comprenant en outre des moyens (2280, 2285) pour transporter ledit dispositif à couche mince (200).

17. Appareil selon l'une quelconque des revendications 1 à 16 comprenant en outre un support de dispositif à vide (2240).

18. Appareil selon l'une quelconque des revendications 1 à 17, comprenant en outre des moyens pour éclairer le premier côté du dispositif à couche mince (200), constitué d'une couche, depuis une première position (1243) pour une première acquisition d'image (6146) et depuis une seconde position (1244) pour une seconde acquisition d'image (6146), la première position et la seconde position étant séparées par une distance de base (1242) selon une direction qui est orthogonale à ladite direction du marquage.

19. Appareil selon les revendications 1 à 18 comprenant en outre au moins une source de lumière structurée (1246).
